# EUROPÄISCHE PATENTSCHRIFT

(11) **EP 1 615 483 B1**
(45) Veröffentlichungstag und Bekanntmachung des Hinweises auf die Patenterteilung: **30.09.2009**
(21) Anmeldenummer: 05014719.8
(22) Anmeldetag: 07.07.2005
(51) Int. Cl.: H05K 1/02

(54) **Leiterkarte mit Karbonisierungssensor**
Circuit board with carbonisation sensor
Circuit imprimé avec capteur de carbonisation

(30) Priorität: 09.07.2004 DE 102004033261
(43) Veröffentlichungstag der Anmeldung: 11.01.2006
(73) Patentinhaber: Diehl Aerospace GmbH, 88662 Überlingen (DE)
(72) Erfinder: Bager, Ralf, 61440 Oberursel (DE)
(74) Vertreter: Diehl Patentabteilung

(56) Entgegenhaltungen:
- DE-U1- 29 923 733
- US-A- 4 567 428
- PATENT ABSTRACTS OF JAPAN Bd. 1996, Nr. 04, 30. April 1996 (1996-04-30) -& JP 07 321427 A (TOSHIBA ELECTRIC APPLIANCE CO LTD), 8. Dezember 1995 (1995-12-08)

## Beschreibung

Die Erfindung betrifft eine Leiterkarte aus Kunststoff mit einem Schutz vor elektrischen Schwelbränden nach Anspruch 1.

Eine Leiterkarte, d.h. ein isolierendes Tragelement von elektronischen Bauteilen und Leiterbahnen, besteht in der Regel aus einem Kunststoff. Der Kunststoff ist wegen des bei Lötvorgängen entstehenden Wärmeeintrags insbesondere ein Duroplast. Üblicherweise wird ein mit Glasfasern verstärktes Epoxidharz verwendet.

Ein defektes elektronisches Bauteil bedingt in vielen elektrischen oder elektronischen Schaltungen die Gefahr einer Feuer- oder einer Rauchentwicklung. Insbesondere bei der heutigen Bestückungstechnik (Klebetechnik, SMD) ist ein elektronisches Bauteil nicht mehr durch Beinchen von der Leiterkarte beabstandet, sondern liegt dieser direkt auf. Eine Folge hiervon ist ein hoher Wärmeeintrag von einem defekten, sich überhitzenden Bauteil in die Leiterkarte.

Durch den Wärmeeintrag kommt es ab einer bestimmten Temperatur zu einer sogenannten Karbonisierung der Leiterkarte. Durch die Hitzeeinwirkung verändert sich die chemische Struktur des Kunststoffs (er "karbonisiert"), wodurch seine ursprünglichen isolierenden Eigenschaften verloren gehen. Die Leiterkarte wird selbst elektrisch leitfähig und damit zu einem elektrischen Verbraucher. Ist die eigentliche Gefahr, die von einem erhitzten Bauteil ausgeht, noch überschaubar, so kommt es durch die Karbonisierung zu einem Lawineneffekt. Die durch die Leitfähigkeit der Leiterkarte entnommene elektrische Energie induziert zusätzlich Wärme, die einen selbstnährenden Prozess in Gang bringt, der sich großflächig über die ganze Leiterkarte ausbreitet. Dabei entstehen nun große Mengen von Qualm und giftigen Dämpfen, solange die Stromzufuhr nicht unterbrochen wird.

Zum Erkennen solcher elektrischer Schwelbrände sind Rauchmelder, die das Vorhandensein von Qualm oder bestimmten Gasen in der Luft melden, oder Temperaturwächter bekannt, die einen unüblichen Temperaturanstieg detektieren. Nachteiligerweise reagieren derartige Einrichtungen erst relativ spät auf einen elektrischen Schwelbrand. Zudem sind sie nicht in der Lage, den Brandherd genau zu lokalisieren. Weiter ist ein hoher Aufwand an Sensoren erforderlich. Für Anwendungen, in denen unter allen Umständen wegen der Gefahr von Personenschäden elektrisch verursachter Qualm vermieden werden muss, z.B. in der Luftfahrt, sind solche Einrichtungen daher nur bedingt zu gebrauchen.

Weiter ist es bekannt, zur Vermeidung von Bränden eine Strombegrenzung in der elektrischen Versorgung einer Schaltungsanordnung vorzusehen. Eine solche Strombegrenzung funktioniert jedoch nachteiligerweise nur bei geringen Nennströmen, so dass der erhöhte Stromfluss im defekten Bauteil oder die durch die Karbonisierung hervorgerufenen Karbonisierungsströme einen merklichen Anteil am Stromfluss haben. Bei solchen Verhältnissen ist eine Karbonisierung der Leiterkarte aufgrund der begrenzten Bauteilströme ohnehin eher selten.

Deshalb ist bei der JP 07 321427 A vorgesehen, mit dem in der Leiterkarte infolge Karbonisierung einsetzenden internen Stromfluss einen Thyristor zu triggern, der die Versorgungsspannung direkt kurzschließt und dadurch eine Sicherung in diesem Kurzschlusskreis durchbrennen lässt, um dadurch die defekte, brandgefährdende Leiterkarte stromlos zu schalten.

Aus der gattungsbildenden US -A- 4,567,428 ist es dagegen bekannt, auf einer mehrlagigen Leiterkarte unter einer abdeckenden Schutzschicht eine vollflächige Sensorelektrode anzuordnen und deren Spannung gegenüber Massepotential oder gegenüber einer Referenzelektrode zu überwachen, um bei einer karbonisierungsbedingten Widerstandsänderung aufgrund des damit einhergehenden Spannungssprunges die elektrische Versorgung der Leiterkarte abzuschalten.

Lediglich zum Messen des elektrischen Oberflächenisolationswiderstandes auf einer Leiterkarte ist es - dort im Zuge der Überprüfung der Fertigungsqualität an einer eigens dafür erstellten Testkarte ohne Schaltungsbahnen und Bauelementebestückung, also nicht zu einer Funktionsüberwachung einer bestückten Leiterplatte im Betrieb - aus der DE 2 99 23 733 U1 als solches bekannt, auf die Oberfläche der Karte in gegeneinander abgesetzten Bereichen Paare von kammartig ineinander greifenden Mustern aufzubringen.

Aufgabe der Erfindung ist es, eine Leiterkarte aus Kunststoff anzugeben, die einen sicheren und schnellen Schutz vor elektrischen Schwelbränden aufweist. Ein Schwelbrand soll so rasch erkannt werden, dass die betroffene Leiterkarte von der elektrischen Versorgung entkoppelt werden kann, bevor elektrisch verursachter Qualm zur Gefahr wird. Der Lawineneffekt soll frühzeitig unterbunden werden.

Diese Aufgabe wird erfindungsgemäß durch eine Leiterkarte aus Kunststoff nach Anspruch 1 gelöst.

Die Erfindung geht dabei von der Erkenntnis aus, dass die Leiterkarte durch die Karbonisierung zu einem elektrischen Leiter wird. Führt die Hitzeentwicklung eines defekten Bauteils zu einem vermehrten Wärmeeintrag in die Leiterkarte und damit zu einer Karbonisierung, so geht damit an dieser Stelle die isolierende Eigenschaft der Leiterkarte verloren. Wird das Material der Leiterkarte zur Isolierung zweier Leiterbahnen voneinander verwendet, so ist die Karbonisierung über eine Änderung des Isolationszustands oder des elektrischen Widerstands der Leiterbahnen zueinander detektierbar. Und zwar lange bevor eine großflächige Entflammung der Leiterkarte zu einer detektierbaren Menge an Qualm und giftigen Dämpfen führt. Der Isolationszustand der Leiterbahnen zueinander ist eine zuverlässige Messgröße zur Erkennung der Karbonisierung der Leiterkarte.

Die Leiterbahnen können dabei als Leiterbahnen im engeren Sinne, aber auch als flächige Gebilde, auch als sogenannte "planes" bezeichnet, ausgebildet sein.

Mittels eines Fehlersignals, welches von dem Überwachungsmittel zur Überwachung des Isolationszustands der Leiterbahnen generiert wird, kann die Information einer Karbonisierung weiter ausgewertet werden. Damit kann die Gefahr einer lawinenartigen Ausbreitung des elektrischen Brandes sicher vermieden werden. Beispielsweise kann das Fehlersignal zur Sperrung der Stromzufuhr für die Leiterkarte verwendet werden.

Die Leiterbahnen können lokal in der Nähe von Leistungsbauteilen angeordnet sein. Es kann auch die gesamte Leiterkarte, nur ein Sektor oder mehrere Sektoren der Leiterkarte mit den Leiterbahnen versehen werden. Die Leiterbahnen können gruppenweise verdichtet oder schlängelartig ausgeführt sein. Die Leiterbahnen können auf der Leiterkarte oder in der Leiterkarte verlegt sein. Es bietet sich aus fertigungstechnischen Gründen an, die Leiterbahnen des Karbonisierungssensors mit den anderen Leiterbahnen der Leiterkarte während der Fertigung integriert auf- oder einzubringen. Als Material kann jedes übliche Material für Leiterbahnen verwendet werden, insbesondere eine Kupferlegierung.

Das Überwachungsmittel ist das von dem Überwachungsmittel erzeugte Fehlersignal wird nach außen zur weiteren Verwertung geführt.

Die Erfindung ermöglicht die Detektion einer Karbonisierung auf der Leiterkarte, noch bevor elektrischer Qualm zu einer Gefahr oder zu einer Bedrohung menschlichen Lebens wird. Durch gezielte lokale Anordnung der Leiterbahnen kann ein betroffener Sektor einer Schaltungsanordnung abgeschaltet werden, bevor größere Folgeschäden auftreten.

Insbesondere in der Luftfahrt oder in anderen hochsicherheitsrelevanten Anwendungen, bei welchen elektrische oder elektronische Schaltungen redundant ausgeführt sind, wird mit einer Leiterkarte mit einem derartigen Karbonisierungssensor eine rasche und lokal begrenzte Abschaltung einzelner betroffener Sektoren ermöglicht, bevor Qualm oder weitreichendere Schäden wie Zerstörung der gesamten Elektronik entstehen. Die Arbeit des defekten Sektors wird von dem redundanten System übernommen. Der defekte Sektor muss noch eine ganze Weile weiterfliegen, bevor er ausgetauscht werden kann. Der Lawineneffekt, der u.a. zum Flugsicherheitsrisiko werden kann, ist sicher vermieden.

Vorteilhafterweise wird das Fehlersignal in eine Schutzvorrichtung geführt, die bei Vorhandensein des Fehlersignals die elektrische Versorgung unterbricht. Auf diese Weise wird das Abschalten des betroffenen Sektors oder der betroffenen Leiterkarte automatisch durchgeführt, sobald das Fehlersignal vorhanden ist. Dies lässt sich durch eine einfache elektronische Schaltung realisieren. Das Fehlersignal des Überwachungsmittels kann beispielsweise erzeugt werden, wenn der ohmsche Widerstand der Leiterbahnen zueinander einen Wert zwischen einigen kΩ und einigen MΩ vorzugsweise zwischen 10 und 100 kΩ, unterschreitet.

Sind Leistungsbauteile auf der Leiterkarte vorhanden, die naturgemäß eine hohe Wärmeentwicklung zeigen, empfiehlt es sich, die sensorischen Leiterbahnen dicht an den zu überwachenden Bauteilen vorbeizuführen.

Häufig ist eine Leiterkarte mehrschichtig aufgebaut und umfasst mehrere Lagen mit jeweiligen Leiter- oder Schaltungsbahnen und Bauelementen. Bis zu 16 Lagen sind keine Seltenheit. Übliche Leiterkarten umfassen etwa 4 Innenlagen und 2 Außenlagen. Zweckmäßigerweise sind die Leiterbahnen des Karbonisierungssensors in einer Innenlage verlegt. Der Karbonisierungssensor kann dann im Fertigungsprozess der Leiterkarte durch eine zusätzliche Innenlage kostengünstig realisiert werden. Die Leiterbahnen können dabei an den zu überwachenden Bauteilen lokalisiert werden, ohne dass hierbei - wie es bei einer einlagigen Leiterkarte der Fall wäre - auf in derselben Lage bereits bestehende Leiterbahnen zum Aufbau der Schaltungsanordnung unter Kontaktierung der Bauelemente direkt Rücksicht genommen werden müsste.

Für Messungen des Isolationszustands der Leiterbahnen über deren ohmschen Widerstand zueinander ist es vorteilhaft, wenn die eine Leiterbahn flächig und die andere Leiterbahn dieser gegenüberliegend und gitter- oder maschenförmig ausgebildet ist. Jede lokale Änderung der Isolierungseigenschaft des zwischen den beiden derart ausgestalteten Leiterbahnen liegenden Kunststoffs der Leiterkarte wirkt sich direkt auf den Widerstand zwischen den Leiterbahnen aus. Alternativ können auch beide Leiterbahnen gitter- oder maschenförmig ausgeführt sein.

Zur Detektion lokaler Karbonisierungseffekte mittels Leiterbahnen ist es sinnvoll, die beiden Leiterbahnen zueinander kammartig auszugestalten. Dies hat insbesondere den Vorteil, dass mit einer Innenlage Ober- und Unterseite der bestückten Leiterkarte zugleich überwacht werden können.

Ein einfaches und kostengünstiges Überwachungsmittel ist eine Gleichstromschaltung, die den ohmschen Widerstand zwischen den Leiterbahnen detektiert und bei Unterschreiten eines vorgegebenen Mindestwiderstands das Fehlersignal erzeugt. Als Mindestwiderstand empfiehlt sich ein Wert zwischen 10 und 100 kΩ.

Zur Netztrennung zwischen Leiterkarte und Überwachungsmittel wird das Überwachungsmittel durch eine Wechselstromschaltung realisiert. Die von den Leiterbahnen des Karbonisierungssensors gebildete Kapazität wird zweckmäßigerweise mit der Induktivität eines Transformators zu einem Schwingkreis verschaltet, der mittels des Transformators über eine Detektorschaltung angeregt wird. Über die Detektorschaltung wird das Schwingverhalten des Schwingkreises detektiert. Ein Verringern des Widerstands der Leiterbahnen zueinander führt zu einer Dämpfung des Schwingkreises und zum Abreißen der Schwingung. Spätestens mit Abreißen der Schwingung wird ein Fehlersignal erzeugt.

Energetisch günstig ist es, wenn die Detektorschaltung auf der Resonanzfrequenz des Schwingkreises betrieben wird. Es ist wenig elektrische Energie zur Anregung des gedämpft schwingenden Schwingkreises notwendig. Der Transformator der Wechselstromschaltung kann dabei direkt auf der Leiterkarte angeordnet sein.

beispiele werden anhand einer Zeichnung näher erläutet. Dabei zeigt:
- Figur 1: schematisch eine Leiterkarte mit einem Karbonisierungssensor und einem Überwachungsmittel, welches im Brandfall die elektrische Versorgung unterbricht,
- Figur 2: in einer perspektivischen Darstellung eine mehrschichtige Leiterkarte, wobei die Leiterbahnen des Karbonisierungssensors in einer Innenlage verlegt sind,
- Figur 3: eine erste Ausgestaltung der Leiterbahnen eines Karbonisierungssensors,
- Figur 4: eine zweite Ausgestaltung der Leiterbahnen eines Karbonisierungssensors,
- Figur 5: eine dem gattungsbildenden Stande der Technik ähnliche Gleichstromschaltung zur Detektion der Veränderung des ohmschen Widerstandes zwischen Leiterbahnen nach Figur 1 bis Figur 5 des Karbonisierungssensors und
- Figur 6: eine erfindungsgemäße Wechselstromschaltung zur Detektion der Veränderung des Dämpfungswiderstandes über der Kapazität zwischen Leiterbahnen nach Figur 1 bis Figur 5 des Karbonisierungssensors.

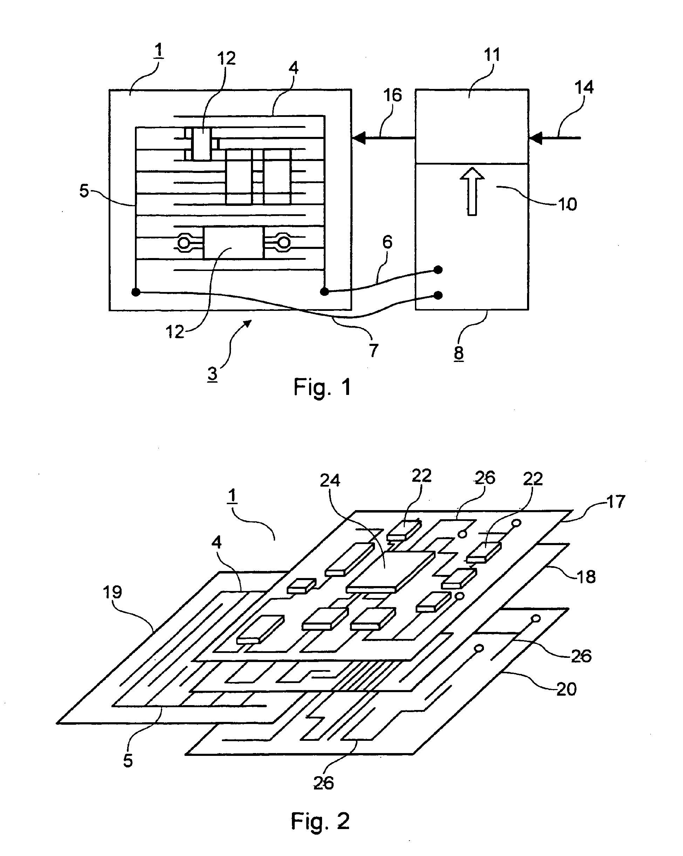

In Figur 1 ist schematisch eine Leiterkarte 1 aus Kunststoff mit einem Karbonisierungssensor 3 dargestellt. Der Karbonisierungssensor 3 umfasst eine erste Leiterbahn 4 und eine zweite Leiterbahn 5, die auf der Oberfläche der Leiterkarte 1 aufgebracht sind. Alternativ könnten die Leiterbahnen 4, 5 auch auf einer Innenlage der Leiterkarte 1 aufgebracht sein. Durch das Material der Leiterkarte 1 sind die Leiterbahnen 4 und 5 voneinander elektrisch isoliert. Die Leiterbahnen 4 und 5 sind aus Kupfer und zueinander kammartig ausgebildet. Über elektrische Anschlüsse 6 und 7 sind die beiden Leiterbahnen 4 bzw. 5 mit einem Überwachungsmittel 8 elektrisch verbunden. Das Überwachungsmittel 8 detektiert bzw. überwacht den Isolationszustand der beiden Leiterbahnen 4 und 5 zueinander.

Schematisch sind auf der Leiterkarte 1 einige elektronische Bauteile 12 dargestellt. Erhitzt sich eines dieser Bauteile 12, so findet ein direkter Wärmeeintrag in das Material der Leiterkarte 1 statt, die sich zunehmend erhitzt. Ab einer bestimmten Temperatur kommt es zu einer Karbonisierung des Kunststoffmaterials, die Leiterkarte 1 wird lokal zu einem elektrischen Leiter. Damit ändert sich aber der Isolationszustand der beiden kammartig verlegten Leiterbahnen 4 und 5 zueinander. Unterschreitet der Isolationszustand oder Widerstand einen vorgegebenen Sollwert, so erzeugt das Überwachungsmittel 8 ein Fehlersignal 10, welches zum Unterbrechen der elektrischen Versorgung 14 in eine Schutzvorrichtung 11 geführt ist. Die Schutzvorrichtung 11 schaltet die elektrische Versorgung 16 der Leiterkarte 1 ab. Ein elektrischer Schwelbrand infolge des selbstnährenden Prozesses der Karbonisierung wird frühzeitig verhindert, und zwar noch ehe elektrisch verursachter Qualm oder giftige Dämpfe zu einer Gefahr für die Umgebung werden. Der Karbonisierungssensor 3 spricht auf lokale Widerstandsänderungen frühzeitig an.

Figur 2 zeigt in einer perspektivischen Darstellung eine mehrschichtige Leiterkarte 1. Zur Verdeutlichung sind die einzelnen Lagen oder Schichten 17, 18, 19, 20 der Leiterkarte 1 einzeln und voneinander getrennt dargestellt. In einer realen mehrschichtigen Leiterkarte 1 umfassen die einzelnen Lagen jeweils separate Schaltungsbahnen 26, die in das Material der Leiterkarte 1, insbesondere in ein mit Glasfasern verstärktes Epoxidharz, eben übereinanderliegend eingelassen sind. Man spricht von sogenannten Innenlagen 18 und 19 sowie von Außenlagen 17 und 20. Die auf den Außenlagen 17 und 20 angeordneten elektronischen Bauteile 22 sind teilweise zu den entsprechenden Schaltungsbahnen der Innenlagen elektrisch durchkontaktiert. Beispielhaft ist auf der Außenlage 17 als Leistungsbauteil ein IC dargestellt, der eine hohe Wärmeentwicklung zeigt.

Auf der Innenlage 19 sind die Leiterbahnen 4 und 5 des Karbonisierungssensors kammartig zueinander angeordnet. Bis auf vorgesehene Durchkontaktierungen muss auf bestehende Schaltungsbahnen 26 in darüber oder darunter liegenden Lagen der Leiterkarte 1 nicht geachtet werden. Die kammartigen Leiterbahnen 4 und 5 werden als zusätzliche Lage der Leiterkarte 1 in deren Fertigungsprozess integriert.

Erwärmt sich aufgrund eines Defekts der IC 24 übermäßig, so führt dies ab einer bestimmten Temperatur zu einer Karbonisierung des darunterliegenden Materials der Leiterkarte 1. Damit ändert sich aber auch der Isolationszustand der Leiterbahnen 4 und 5 in der Innenlage 19 zueinander. Ein Schwelbrand kann rasch und sicher vermieden werden.

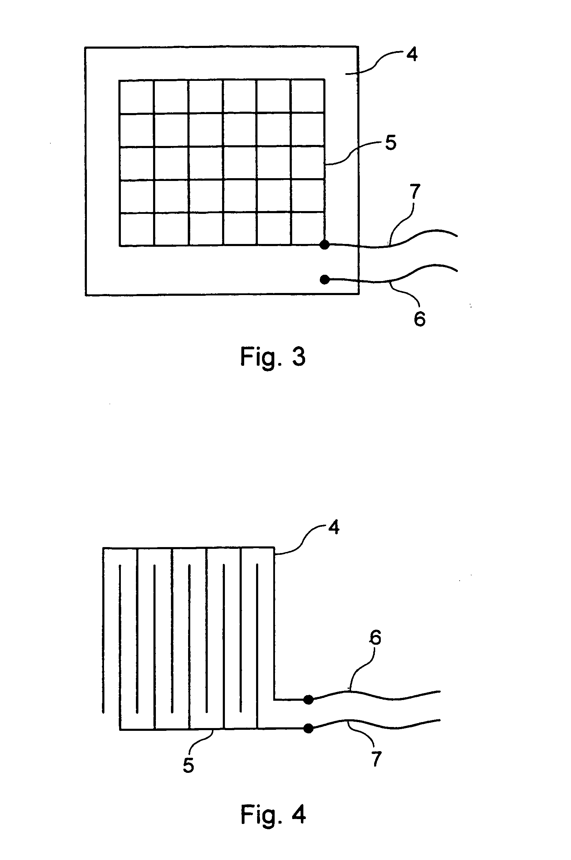

Figur 3 zeigt eine erste Ausgestaltung der Leiterbahnen 4 und 5, wie sie sich insbesondere zur Messung des ohmschen Widerstands zueinander als Maß für den Isolationszustand eignet. Eine Leiterbahn, nämlich die Leiterbahn 4, ist in dieser Ausbildungsform flächig als sogenannte "plane" ausgeführt. Die andere Leiterbahn 5 ist gitterförmig ausgebildet. Zwischen beiden Leiterbahnen 4 und 5 befindet sich das Material der Leiterkarte (hier nicht dargestellt). Die beiden Anschlüsse 6 und 7 führen zu dem angeschlossenen Überwachungsmittel.

Führt ein überhitztes Bauteil lokal an irgendeiner Stelle zu einer Karbonisierung des zwischen den Leiterbahnen 4 und 5 befindlichen Materials der Leiterkarte, so ändert sich aufgrund der flächenhaften Ausführung der ohmsche Widerstand zwischen den Leiterbahnen 4 und 5. Die Karbonisierung führt lokal zu einem "Kurzschluss zwischen den Leiterbahnen 4 und 5, was über eine Messung des ohmschen Widerstands detektierbar ist. Die Detektion kann beispielsweise derart vorgenommen werden, dass bei Unterschreiten eines Mindestwerts für den ohmschen Widerstands von dem Überwachungsmittel ein Fehlersignal ausgelöst wird, welches zum Abschalten der elektrischen Versorgung der Leiterkarte herangezogen werden kann. Ein günstiger Mindestwert für den Widerstand liegt etwa zwischen 10 kΩ und einigen MΩ.

In Figur 4 ist eine andere Ausgestaltung der Leiterbahnen 4 und 5 dargestellt, wie sie sich insbesondere zu einer Detektion des Isolationszustands der Leiterbahnen 4 und 5 zueinander in einer Ebene eignet. Beide Leiterbahnen sind kammartig ausgeführt, wobei die Zähne der Kämme jeweils ineinander greifen. Die Leiterbahnen sind dabei durch das Material der Leiterkarte voneinander beabstandet. Die elektrischen Anschlüsse 6 und 7 sind wiederum zu einem externen Überwachungsmittel geführt. Durch eine Karbonisierung aufgrund eines überhitzten Bauteils ändert sich das Material der Leiterkarte lokal von einem elektrischen Isolator zu einem elektrischen Leiter. Die Impedanz der Leiterbahnen 4 und 5 ändert sich und kann beispielsweise über eine Wechselstromschaltung abgegriffen bzw. detektiert werden.

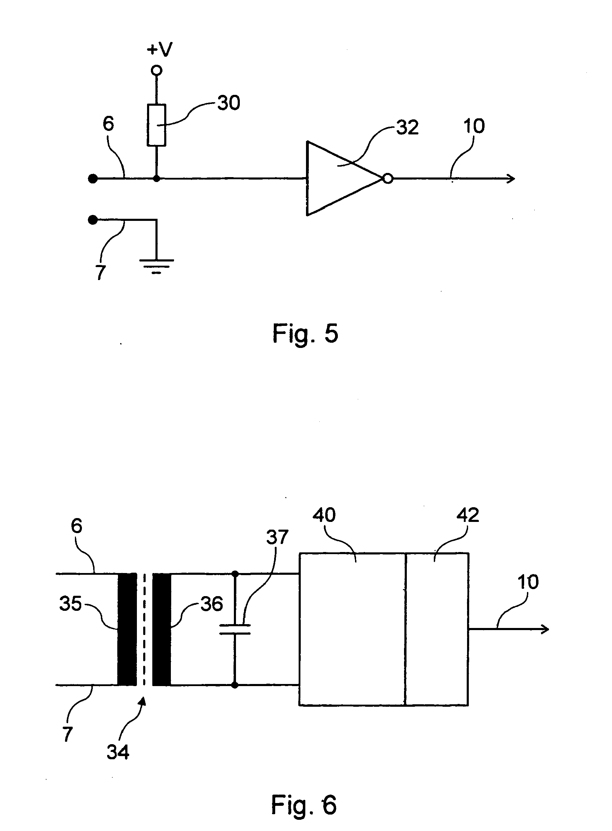

Ein Prinzipschaltbild einer elektrischen Schaltung zur Detektion des ohmschen Widerstands der Leiterbahnen des Karbonisierungssensors ist in Figur 5 gezeigt. An den elektrischen Anschlüssen 6 und 7 sind die Leiterbahnen 4 bzw. 5, beispielsweise wie in Figur 3 gezeigt, angeschlossen. Eine Leiterbahn ist über den Anschluss 6 geerdet. Über den Anschluss 7 und einen Widerstand 30 ist die andere Leiterbahn auf das Potential V+ gelegt. Der digitale Inverter 32 verstärkt die an dem von den Leiterbahnen gebildeten Widerstand abfallende Spannung. Als Fehlersignal 10 kann das Ausgangssignal des digitalen Inverters 32 herangezogen werden.

In Figur 6 ist das Prinzipbild einer Wechselstromschaltung zur Detektion der Impedanz der Leiterbahnen des Karbonisierungssensors gezeichnet. Die Leiterbahnen sind über die Anschlüsse 6 und 7 an die Sekundärspule 35 eines Transformators 34 angeschlossen. Die Leiterbahnen sind entsprechend Figur 4 ausgeführt. Der aus den Leiterbahnen 4, 5 des Karbonisierungssensors gebildete Kondensator und die Induktivität des Transformators 34 bilden einen Schwingkreis, der gedämpfte Schwingungen ausführt. Über die Primärspule 36 des Transformators 34 wird der Schwingkreis angeregt. Idealerweise erfolgt die Anregung aus energetischen Gründen mit der Resonanzfrequenz des Schwingkreises. Zur Erzeugung der entsprechenden Frequenz ist ein Oszillator 40 vorgesehen, der über eine Detektorschaltung 42 überwacht wird. Parallel zur Spule 36 ist im Ausführungsbeispiel ein Kondensator 37 geschaltet, über den die Schwingfrequenz veränderbar ist. Dieser könnte alternativ auch parallel zur Spule 35 geschaltet sein. Über den Transformator 34 ist der Karbonisierungssensor von der Überwachungsschaltung entkoppelt.

Über die nicht näher dargestellte Detektorschaltung 42 wird das Schwingverhalten des Schwingkreises analysiert. Findet in der Leiterkarte lokal eine Karbonisierung statt, so ändert sich die Impedanz des von den Leiterbahnen gebildeten Sensors. Findet ein lokaler Kurzschluss statt, so wird der Sensor überbrückt. Die Schwingung im Schwingkreis reißt ab. Die Detektorschaltung 42 gibt ein Fehlersignal 10 aus.

### Bezugszeichenliste

- 1: Leiterkarte
- 3: Karbonisierungssensor
- 4: erste Leiterbahn
- 5: zweite Leiterbahn
- 6: erster Anschluss
- 7: zweiter Anschluss
- 8: Überwachungsmittel
- 10: Fehlersignal
- 11: Schutzvorrichtung
- 12, 22: elektronische Bauteile
- 14: elektrische Versorgung
- 16: Versorgung Leiterkarte
- 17, 18, 19, 20: Leiterkartenlagen
- 24: IC
- 26: Schaltungsbahnen
- 30: Ohmscher Widerstand
- 32: digitaler Inverter
- 34: Transformator
- 35: Sekundärspule
- 36: Primärspule
- 37: Kondensator
- 40: Oszillator
- 42: Detektorschaltung

## Patentansprüche

1. Leiterkarte (1) aus Kunststoff mit einem Karbonisierungssensor (3) zum Schutz vor elektrischen Schwelbränden, wobei der Karbonisierungssensor (3) eine auf der Leiterkarte (1) angeordnete erste (4) und zweite (5) Leiterbahn, die durch den Kunststoff voneinander elektrisch isoliert sind, sowie ein Überwachungsmittel (8) umfasst, das als Wechselstromschaltung die von den Leiterbahnen (4, 5) gebildete Impedanz detektiert und bei Unterschreiten eines vorgegebenen Mindestwertes ein Fehlersignal (10) erzeugt, indem die von den Leiterbahnen (4, 5) gebildete Kapazität und die Induktivität eines auf der Leiterkarte (1) angeordneten Transformators (34) einen mittels des Transformators (34) über eine Detektorschaltung (42) angeregten Schwingkreis bilden, auf dessen Resonanzfrequenz die Detektorschaltung (42) betrieben wird, wobei über die Detektorschaltung (42) das Schwingverhalten des Schwingkreises detektiert und bei Abreißen der Schwingung das Fehlersignal (10) erzeugt wird.

2. Leiterkarte (1) nach Anspruch 1,
wobei das Fehlersignal (10) in eine Schutzvorrichtung (11) geführt ist, die bei Vorhandensein des Fehlersignals (10) die elektrische Versorgung (16) unterbricht.

3. Leiterkarte (1) nach Anspruch 1 oder 2,
wobei die Leiterbahnen (4, 5) dicht an den zu überwachenden Bauteilen (12), insbesondere den Leistungsbauteilen (24), vorbeigeführt sind.

4. Leiterkarte (1) nach einem der vorhergehenden Ansprüche,
umfassend mehrere Lagen (17, 18, 19, 20), wobei die Leiterbahnen(4, 5) des Karbonisierungssensors (3) in einer Innenlage (18, 19) verlegt sind.

5. Leiterkarte (1) nach einem der vorhergehenden Ansprüche,
wobei eine Leiterbahn (4) flächig und die andere Leiterbahn (5) dieser gegenüberliegend und gitterförmig ausgebildet ist.

6. Leiterkarte (1) nach einem der Ansprüche 1 bis 5,
wobei die beiden Leiterbahnen (4, 5) kammartig zueinander ausgebildet sind.

## Claims

1. Printed circuit card (1) made of plastic with a carbonization sensor (3) for protection against smouldering electrical fires, the carbonization sensor (3) comprising a first (4) and second (5) conductor track which are electrically insulated from one another by the plastic, arranged on the printed circuit card (1), and also monitoring means (8), which, as an a.c. circuit, detects the impedance formed by the conductor tracks (4, 5) and produces a fault signal (10) when it falls below a prescribed minimum value, in that the capacitor formed by the conductor tracks (4, 5) and the inductance of a transformer (34), arranged on the printed circuit card (1), form an oscillating circuit, which is excited by means of the transformer (34) via a detector circuit (42) and on the resonant frequency of which the detector circuit (42) is operated, the oscillating behaviour of the oscillating circuit being detected by the detector circuit (42) and the fault signal (10) being produced when the oscillation breaks off.

2. Printed circuit card (1) according to Claim 1, the fault signal (10) being routed into a protective device (11), which in the presence of the fault signal (10) interrupts the electrical supply (16).

3. Printed circuit card (1) according to Claim 1 or 2, the conductor tracks (4, 5) being routed in such a way that they pass close by the components (12) to be monitored, in particular the power components (24).

4. Printed circuit card (1) according to one of the preceding claims, comprising a number of layers (17, 18, 19, 20), the conductor tracks (4, 5) of the carbonization sensor (3) being laid in an inner layer (18, 19).

5. Printed circuit card (1) according to one of the preceding claims, one conductor track (4) being formed so as to cover a surface area and the other conductor track (5) being formed opposite it and in the form of a grid.

6. Printed circuit card (1) according to one of Claims 1 to 5, the two conductor tracks (4, 5) being formed in a comb-like manner in relation to one another.

## Revendications

1. Circuit imprimé (1) en matière plastique comprenant un capteur de carbonisation (3) pour la protection contre les feux couvants, le capteur de carbonisation (3) comprenant une première (4) et une deuxième piste conductrice (5) disposées sur le circuit imprimé (1) et isolées électriquement l'une de l'autre par la matière plastique, ainsi qu'un moyen de surveillance (8) qui détecte comme circuit à courant alternatif l'impédance formée par les pistes conductrices (4, 5) et qui, en cas de franchissement vers le bas d'une valeur minimale prédéfinie, génère un signal de défaut (10) en ce que la capacité formée par les pistes conductrices (4, 5) et l'impédance d'un transformateur (34) disposé sur le circuit imprimé (1) forment un circuit oscillant, excité au moyen du transformateur (34) par le biais d'un circuit de détection (42) et à la fréquence de résonance duquel fonctionne le circuit de détection (42), le comportement oscillant du circuit oscillant étant détecté par le biais du circuit de détection (42) et le signal de défaut (10) étant généré en cas d'interruption de l'oscillation.

2. Circuit imprimé (1) selon la revendication 1, le signal de défaut (10) étant acheminé dans un dispositif de protection (11) qui interrompt l'alimentation électrique (16) en présence du signal de défaut (10).

3. Circuit imprimé (1) selon la revendication 1 ou 2, les pistes conductrices (4, 5) étant guidées à proximité étroite des composants à surveiller (12), notamment des composants de puissance (24).

4. Circuit imprimé (1) selon l'une des revendications précédentes, comprenant plusieurs couches (17, 18, 19, 20), les pistes conductrices (4, 5) du capteur de carbonisation (3) étant posées dans une couche intérieure (18, 19).

5. Circuit imprimé (1) selon l'une des revendications précédentes, une piste conductrice (4) étant de forme plane et l'autre piste conductrice (5) étant opposée à celle-ci et réalisée en forme de grille.

6. Circuit imprimé (1) selon l'une des revendications 1 à 5, les deux pistes conductrices (4, 5) étant réalisées en forme de peigne l'une par rapport à l'autre.
